# EUROPÄISCHE PATENTSCHRIFT

(11) **EP 2 186 143 B1**
(45) Veröffentlichungstag und Bekanntmachung des Hinweises auf die Patenterteilung: **04.03.2015**
(21) Anmeldenummer: 08830682.4
(22) Anmeldetag: 25.08.2008
(51) Int. Cl.: H01L 33/08, H01L 33/06

(54) **LICHTEMITTIERENDE STRUKTUR**
LIGHT-EMITTING STRUCTURE
STRUCTURE ÉLECTROLUMINESCENTE

(30) Priorität: 10.09.2007 DE 102007043096; 06.12.2007 DE 102007058723
(43) Veröffentlichungstag der Anmeldung: 19.05.2010
(73) Patentinhaber: OSRAM Opto Semiconductors GmbH, 93055 Regensburg (DE)
(72) Erfinder: AVRAMESCU, Adrian, Stefan, 93051 Regensburg (DE); LUGAUER, Hans-Jürgen, 93161 Sinzing (DE); PETER, Matthias, 93087 Alteglofsheim (DE); MILLER, Stephan, 93080 Pentling (DE)
(74) Vertreter: Epping - Hermann - Fischer
(86) Internationale Anmeldenummer: PCT/DE2008/001426
(87) Internationale Veröffentlichungsnummer: WO 2009/033448

(56) Entgegenhaltungen:
- EP-A- 1 160 883
- EP-A- 1 670 068
- DE-A1-102006 002 151
- DE-A1-102006 025 964
- GB-A- 2 361 354
- US-A1- 2003 151 044
- US-A1- 2004 183 088
- US-A1- 2006 049 415
- US-A1- 2007 114 540
- QI Y D ET AL: "Dual wavelength InGaN/GaN multi-quantum well LEDs grown by metalorganic vapor phase epitaxy" JOURNAL OF CRYSTAL GROWTH, ELSEVIER, AMSTERDAM, NL, Bd. 272, Nr. 1-4, 10. Dezember 2004 (2004-12-10), Seiten 333-340, XP004658493 ISSN: 0022-0248

## Beschreibung

Die Erfindung betrifft eine lichtemittierende Struktur, die Indium-Gallium-Nitrid-Quantentöpfe enthält.

Diese Patentanmeldung beansprucht die Prioritäten der deutschen Patentanmeldung 10 2007 043 096.7 und der deutschen Patentanmeldung 10 2007 058 723.8.

In lichtemittierenden Strukturen werden Indium-Gallium-Nitrid-Quantentöpfe (im Weiteren InGaN-Quantentöpfe genannt) getrennt durch (In)GaN Sperrschichten. Durch den Heteroübergang zwischen den Quantentöpfen und den Sperrschichten wird eine Potenzialbarriere gebildet, die die Injektion von Ladungsträgern, also von Elektronen und Löchern erschwert. Die Potenzialbarrieren der Heteroübergänge entstehen durch die hohen piezoelektrischen Felder zwischen den Quantentöpfen und den Sperrschichten. Da mit der Anzahl der Quantentöpfe auch die Anzahl der Heteroübergänge ansteigt, ist es schwierig, eine lichtemittierende Struktur aufzubauen, die mehrere Quantentöpfe enthält.

In der Druckschrift US 2003/0151044 A1 ist ein Licht emittierendes Bauteil angegeben.

Ein weißes Licht emittierendes Bauteil sowie eine Herstellungsmethode hierfür sind in der Druckschrift EP 1 670 068 A1 offenbart.

Eine zu lösende Aufgabe besteht darin, eine lichtemittierende Struktur anzugeben, die eine hohe Strahlungseffizienz aufweist.

Es wird eine lichtemittierende Struktur gemäß Anspruch 1 angegeben, die ein p-dotiertes Gebiet und ein n-dotiertes Gebiet umfasst. Das p-dotierte Gebiet ist zur Injektion von Löchern vorgesehen. Das n-dotierte Gebiet ist zur Injektion von Elektronen vorgese-hen.

Zwischen den genannten Gebieten ist mindestens ein InGaN-Quantentopf einer ersten Sorte angeordnet. Vorzugsweise sind zwischen den Gebieten mehrere Quantentöpfe der ersten Sorte angeordnet. Die Quantentöpfe der ersten Sorte sind voneinander getrennt durch (In) GaN-Sperrschichten einer ersten Sorte, das heißt Sperrschichten einer ersten Sorte, die zumindest GaN und gegebenenfalls zusätzlich Indium enthalten können.

Darüber hinaus ist mindestens ein InGaN-Quantentopf einer zweiten Sorte vorgesehen. Der Quantentopf der zweiten Sorte zeichnet sich dadurch aus, dass er einen höheren Indiumgehalt aufweist als der Quantentopf der ersten Sorte.

Insbesondere weist der Quantentopf der ersten Sorte einen relativ niedrigen Indiumgehalt und der Quantentopf der zweiten Sorte einen relativ hohen Indiumgehalt auf. Die lichtemittierende Struktur enthält somit eine aktive Zone, die insbesondere gebildet ist aus einer Vielzahl von Quantentöpfen mit einem niedrigen Indiumgehalt, welche zwischen Sperrschichten eingebettet sind. Darüber hinaus ist mindestens ein Quantentopf mit einem hohen Indiumgehalt in der aktiven Zone vorgesehen. Vorzugsweise grenzt der mindestens eine Quantentopf der ersten Sorte an das n-dotierte Gebiet an, während der mindestens eine Quantentopf der zweiten Sorte angrenzend an das p-dotierte Gebiet angeordnet ist. Die Quantentopf der ersten Sorte ist also auf der n-Seite der aktiven Zone ange-ordnet, während der Quantentopf der zweiten Sorte auf der p-Seite der aktiven Zone der Struktur angeordnet ist. Dieser Aufbau ermöglicht es, bereits entkommene Ladungsträger weiter zu injizieren, wodurch die Effizienz des lichtemittierenden Bauelements verbessert werden kann. Insbesondere ergibt sich der Vorteil, dass der niedrige Indiumgehalt der Quantentöpfe der ersten Sorte zu verringerten piezoelektrischen Feldern an den Heteroübergängen zu den Sperrschichten führt. Dies ermöglicht insbesondere die effektive Injektion von Löchern in die Quantentopfstruktur, verglichen mit dem Fall einer Quanten-topfstruktur mit einem hohen Indiumgehalt.

Im Falle des Quantentopfes mit dem hohen Indiumgehalt auf der Seite der aktiven Zone, die an das p-dotierte Gebiet angrenzt, kann die Potenzialbarriere auf der Seite des p-dotierten Gebiets durch eine Kontrolle der p-Dotierung und die Wahl eines geeigneten Dotierprofils in der Nähe der Quantentopfstruktur verringert werden. Insbesondere wird als p-Dotierstoff Magnesium verwendet.

In einer Ausführungsform der lichtemittierenden Struktur sind die Quantentöpfe so ausgebildet, dass der Quantentopf der ersten Sorte Licht im UV-Bereich emittiert, während der Quantentopf der zweiten Sorte Licht im blau-grünen Bereich emit-tiert.

Gemäß einer Ausführungsform ist es vorgesehen, dass der Indiumgehalt der Quantentöpfe der ersten Sorte so eingestellt ist, dass sie Strahlung in einem Wellenlängebereich zwischen 370 nm und 440 nm emittieren. Werden die Sperrschichten der ersten Sorte aus GaN hergestellt, so liegt die Wellenlänge der von den Quantentöpfen der ersten Sorte emittierten Strahlung insbesondere zwischen 370 nm und 420 nm. Werden die Sperrschichten der ersten Sorte hingegen aus InGaN gebildet, so beträgt die Wellenlänge insbesondere zwischen 390 nm und 440 nm.

Der Indiumgehalt bei den Quantentöpfen der ersten Sorte wird vorzugsweise zwischen 4 % und 12 % eingestellt. Insbesondere enthalten die Quantentöpfe der ersten Sorte InₓGa₁₋ₓN, wobei 0.04 ≤ x ≤ 0.12.

Die Dicke der Quantentöpfe der ersten Sorte beträgt vorzugs-weise zwischen 2 nm und 7 nm, insbesondere zwischen 2 nm und 4 nm.

Bevorzugt wird der Indiumgehalt der Sperrschichten der ersten Sorte so eingestellt, dass er kleiner als 5 % ist. Insbesondere enthalten die Sperrschichten der ersten Sorte InₓGa₁₋ₓN, wobei x ≤ 0.05. Die Differenz zwischen dem Indiumgehalt in den Sperrschichten der ersten Sorte und den Quantentöpfen der ersten Sorte sollte kleiner als 7 % sein. Besonders bevorzugt sollte der Unterschied kleiner als 5 % sein.

Gemäß einer Ausführungsform der Struktur ist es vorgesehen, dass der Indiumgehalt des Quantentopfes der zweiten Sorte so eingestellt ist, dass er Strahlung in einem Wellenlängenbereich zwischen 440 nm und 580 nm emittiert.

Der Indiumgehalt des Quantentopfes der zweiten Sorte beträgt vorzugsweise zwischen 12 % und 25 %. Insbesondere enthält der Quantentopf der zweiten Sorte InₓGa₁₋ₓN, wobei 0.12 ≤ x ≤ 0.25. Die Dicke des Quantentopfes der zweiten Sorte liegt vorzugsweise zwischen 2 nm und 7 nm, insbesondere zwischen 2 nm und 4 nm.

Um ferner das Intensitätsverhältnis zwischen der langwelligen und der kurzwelligen Strahlung zu kontrollieren, kann die Dotierung und das Dotierprofil der Sperrschichten geeignet eingestellt werden. Gemäß Anspruch 1 sind die Sperr-schichten der ersten Sorte mit Silizium dotiert und zwar mit einer Konzentration zwischen 1,0 x 10¹⁷ l/cm³ und 2,0 x 10¹⁹ l/cm³.

Zur Trennung der Quantentöpfe der ersten Sorte vom Quantentopf der zweiten Sorte kann ferner eine Sperrschicht einer zweiten Sorte zwischen diesen beiden Sorten von Quantentöpfen vorgesehen sein. Besonders bevorzugt grenzen ein Quantentopf der ersten Sorte und ein Quantentopf der zweiten Sorte direkt an die Sperrschicht der zweiten Sorte an. Um das Intensitätsverhältnis zwischen der langwelligen und der kurzwelligen Strahlung geeignet einzustellen, ist die Sperrschicht der zweiten Sorte mit Silizium dotiert mit einer Konzentration von nicht mehr als 5 x 10¹⁷ l/cm³. Die Sperrschicht der zweiten Sorte ist die Sperrschicht zwischen dem Quantentopf mit dem hohen Indiumgehalt und dem Quantentopf mit dem niedrigen Indiumgehalt.

Ein weiterer Parameter für die Kontrolle des Intensitätsverhältnisses besteht in der geeigneten Wahl der Dicke der Sperrschichten. Vorzugsweise beträgt die Dicke der Sperrschichten zwischen 3 nm und 15 nm , insbesondere zwischen 6 nm und 12 nm. Dabei kann die Dicke der Sperrschichten der ersten Sorte und die Dicke der Sperrschicht der zweiten Sorte gleich oder auch unterschiedlich gewählt werden.

Um das Intensitätsverhältnis der langwelligen und der kurzwelligen Emission einzustellen, kann auch die Anzahl der Quantentöpfe der ersten Sorte eingestellt werden.

Die Anzahl der Quantentöpfe liegt bevorzugt zwischen 1 und 30.

Zwar treten auf der an das p-dotierte Gebiet angrenzenden Seite der aktiven Zone aufgrund des relativ hohen Indiumgehalts des Quantentopfs der zweiten Sorte höhere Potenzialbarrieren auf. Diese können jedoch durch eine geeignete p-Dotierung reduziert werden, so dass eine ausreichend gute Löcherleitung gewährleistet ist. Allerdings nimmt die Löcherleitung zu den Quantentöpfen der ersten Sorte hin ab. Um dennoch eine ausreichend gute Löcherinjektion in die Quantentöpfe der ersten Sorte zu ermöglichen, wird die Potenzialbarriere abgesenkt. Dies kann durch einen relativ niedrigen Indiumgehalt in den Quantentöpfen der ersten Sorte erzielt werden. Der Indiumgehalt ist mit Vorteil in den Quantentöpfen der ersten Sorte geringer als in dem Quantentopf der zweiten Sorte. Ferner wird vorzugsweise die Differenz zwischen dem Indiumgehalt der Quantentöpfe der ersten Sorte und dem Indiumgehalt der Sperrschichten der ersten Sorte verringert, was durch eine Erhöhung des Indiumgehalts in den Sperrschichten erreicht werden kann. Die verringerte Differenz führt jedoch zu einem geringeren Einschluss von Ladungsträgern in den Quantentöpfen. Daher werden vorteilhafterweise mehrere Quantentöpfe der ersten Sorte verwendet, während ein Quantentopf der zweiten Sorte ausreichend sein kann. Die Anzahl der Quantentöpfe der ersten Sorte ist also vorzugsweise größer als die Anzahl der Quantentöpfe der zweiten Sorte. Die hier beschriebene Struktur kann verwendet werden, um die Effizienz und die Farbwiedergabe eines Leuchtstoffs zu verbessern. Der Leuchtstoff kann in Reinform vorliegen und somit in einem bevorzugten Wellenlängenbereich abstrahlen. Alternativ kommt eine Mischung aus Leuchtstoffen in Betracht, die ein relativ breites Spektrum an Wellenlängen abstrahlt.

Der Leuchtstoff oder die Mischung aus Leuchtstoffen kann hinsichtlich der Helligkeit und/oder der Farbwiedergabe opti-miert werden, insbesondere in Bezug auf die relative Intensität der Strahlungspeaks, die von der Struktur abgestrahlt werden.

Die hier beschriebene Struktur kann vor allem verwendet werden in Verbindung mit einem Leuchtstoff oder Mischungen aus Leuchtstoffen, die ähnliche Emissionswellenlängen aufweisen, wie die Quantentöpfe der Struktur. Der Leuchtstoff kann op-tisch durch das von der Struktur abgestrahlte kurzwellige Licht gepumpt werden. Das resultierende abgestrahlte Spektrum zeigt sich dann beispielsweise in einer verstärkten Emission im blauen oder grünen Bereich mit einer verbreiterten Hintergrundemission im blauen oder grünen Bereich. Diese breitbandige blaue oder breitbandige grüne Abstrahlung wird vom menschlichen Auge als angenehmer beziehungsweise weicher empfunden als das in einem relativ schmalen Wellenlängenbereich abgestrahlte Licht der Quantentöpfe.

Falls erforderlich, kann der Anteil des kurzwelligen Lichts, der nach der Absorption im Leuchtstoff übrig bleibt, durch ein entsprechendes Absorbermaterial, das als Beschichtung o-der als Verkapselung vorliegen kann, absorbiert werden.

Dementsprechend wird ein Bauelement mit einer lichtemittierenden Struktur angegeben, bei dem der lichtemittierenden Struktur in Abstrahlrichtung der Quantentöpfe mindestens ein Leuchtstoff nachgeordnet ist, der durch das Licht der Quantentöpfe , insbesondere der Quantentöpfe der ersten Sorte, optisch gepumpt wird.

Der Leuchtstoff kann dabei in Reinform oder als Mischung mehrerer Leuchtstoffe vorliegen. Beispielsweise kann der Leuchtstoff oder die Mischung ähnliche Emissionswellenlängen wie die Quantentöpfe aufweisen.

Der Leuchtstoff kann in von einander getrennten Sorten vorliegen, die ihrerseits Licht in unterschiedlichen Wellenlängenbereichen emittieren.

Die lichtemittierende Struktur und das Bauelement werden im Folgenden anhand von Ausführungsbeispielen näher erläutert.
Figur 1 zeigt eine lichtemittierende Struktur in einem schematischen Querschnitt.
Figur 2 zeigt das von der lichtemittierenden Struktur emittierte Spektrum in Abhängigkeit von der Wellenlänge.
Figur 3 zeigt ein Bauelement mit einer lichtemittierenden Struktur und einer Mischung aus Farbstoffen.
Figur 4 zeigt ein Bauelement mit einer lichtemittierenden Struktur und verschiedenen Leuchtstoffen.
Figur 5 zeigt das von einem Bauelement gemäß Figur 4 emittierte Licht in Abhängigkeit von der Wellenlänge.
Figur 6 zeigt das von einem Bauelement gemäß Figur 3 emittierte Licht mit einem breiten Peak im Bereich des blauen Lichts in Abhängigkeit von der Wellenlänge.
Figur 7 zeigt das von einem Bauelement gemäß Figur 3 emittierte Licht mit einem breiten Peak im Bereich des grünen Lichts in Abhängigkeit von der Wellenlänge.

Die Figuren sind nicht als maßstabsgerecht anzusehen, weswegen zur besseren Darstellung einzelne Dimensionen vergrößert oder verkleinert dargestellt sein können.

Elemente, die die gleiche Funktion ausüben, sind in den Figuren mit gleichem Bezugszeichen versehen.

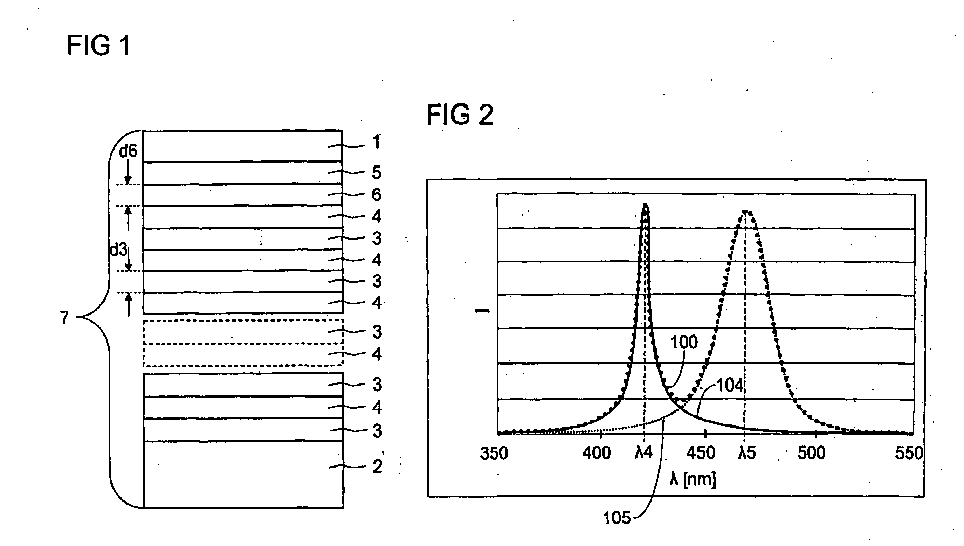

Figur 1 zeigt eine lichtemittierende Struktur 7, mit einem Stapel von übereinander liegenden Schichten. Auf der Unterseite der Struktur befindet sich ein n-dotiertes Gebiet 2, das dazu vorgesehen ist, Elektronen in die lichtemittierende Struktur bei Anlegen einer elektrischen Spannung zu injizieren.

Oberhalb des n-dotierten Gebietes sind eine Mehrzahl von Quantentöpfen 4 einer ersten Sorte angeordnet. Die Quantentöpfe 4 der ersten Sorte enthalten InGaN, wobei der Indiumgehalt so gewählt ist, dass die Quantentöpfe bei Anregung im Bereich von UV- beziehungsweise violettem Licht Strahlung emittieren. Die Quantentöpfe 4 der ersten Sorte sind durch Sperrschichten 3 einer ersten Sorte voneinander getrennt. Im oberen Bereich der lichtemittierenden Struktur 7 ist ein Quantentopf 5 einer zweiten Sorte angeordnet, der ebenfalls Indium-Gallium-Nitrid enthält, wobei der Indiumgehalt des Quantentopfes 5 der zweiten Sorte so gewählt ist, dass eine Emission im blauen beziehungsweise grünen Spektralbereich stattfindet. Der Quantentopf 5 der zweiten Sorte ist durch eine Sperrschicht 6 der zweiten Sorte von einem direkt angrenzenden Quantentopf 4 der ersten Sorte getrennt. Vorzugsweise befinden sich sämtliche Quantentöpfen 4 der ersten Sorte auf einer Seite des Quantentopfes 5 der zweiten Sorte.

Auf der Oberseite des Quantentopfes 5 der zweiten Sorte befindet sich ein p-leitendes Gebiet 1, das der Injektion von Löchern in die lichtemittierende Struktur 7 dient. Die Dicke d6 der Sperrschicht 6 der zweiten Sorte kann vorzugsweise zwischen 3 nm und 15 nm, insbesondere zwischen 2 nm und 6 nm, betragen. Dasselbe gilt für die Dicke d3 der Sperrschichten 3 der ersten Sorte, welche eine Dicke im Bereich zwischen 3 nm und 15 nm, insbesondere zwischen 2 nm und 6 nm, aufweisen. Die Dicken d3 und d6 können gleich oder auch verschieden voneinander sein.

Um die Potenzialbarriere zur p-Seite zu kontrollieren, ist ein Magnesium-Dotierprofil vorgesehen, wobei die Magnesiumkonzentration beginnend an der unteren Grenze des p-leitenden Gebiets 1 kontinuierlich ansteigt, bis ein Maximum in einem Abstand zwischen 2. nm und 15 nm von der Untergrenze des p-leitenden Gebietes erreicht ist. Die maximale Konzentration an Magnesium beträgt dabei zwischen 1,0 und 100 x 10¹⁸ 1/cm³. Von diesem Maximum sinkt die Magnesiumkonzentration in Richtung auf den p-Kontakt der Anordnung hin wieder etwas ab bis sie eine minimale Konzentration erreicht. Die minimale Magnesiumkonzentration beträgt dabei etwa ein Drittel bis die Hälfte der Magnesiumkonzentration im Maximum. In Richtung auf den p-Kontakt, der beispielsweise als Galliumnitrid-Schicht ausgeführt sein kann, steigt die Magnesiumkonzentration weiter an und ist dann vorzugsweise größer als 5,0 x 10¹⁹ 1/cm³.

Die Anzahl der Quantentöpfe der ersten Sorte kann variieren, was durch die mit gestrichelten Linien markierte Kombination von ersten Quantentöpfen 4 der ersten Sorte mit Sperrschichten 3 der ersten Sorte angedeutet ist. Die Anzahl der Quantentöpfe kann beispielsweise zwischen 1 und 30 variieren. Die gesamte in Figur 1 dargestellte Struktur kann Teil eines Bauelements sein, insbesondere einer lichtemittierenden Diode (LED).

Figur 2 zeigt das Emissionsspektrum einer lichtemittierenden Struktur, wie sie beispielhaft in Figur 1 dargestellt ist. Die Quantentöpfe der ersten Sorte strahlen Licht ab, dessen Intensität I in Abhängigkeit von der Wellenlänge λ durch die Kurve 104 gezeigt ist. Die Kurve 104 zeigt die Lichtemission in Abhängigkeit von der Wellenlänge für die Quantentöpfe 4 der ersten Sorte.

Der Quantentopf der zweiten Sorte emittiert Licht, dessen Intensität in Abhängigkeit von der Wellenlänge dargestellt ist durch die Kurve 105. Diese zeigt die Emission des Quantentopfes der zweiten Sorte in Abhängigkeit von der Wellenlänge. Das Gesamtspektrum des emittierten Lichts ist durch die Kurve 100 gezeigt.

Das Strahlungsspektrum gemäß Figur 2 ergibt sich beispielsweise durch Verwendung von Sperrschichten der ersten Sorte mit einer Indiumkonzentration von nicht mehr als 3 %, Quäntentöpfen der ersten Sorte mit einer Indiumkonzentration von etwa 8 %, Sperrschichten der zweiten Sorte mit einer Indiumkonzentration von nicht mehr als 5 % und einem Quantentopf der zweiten Sorte mit einer Indiumkonzentration von bis zu 18 %. Insbesondere enthalten die Sperrschichten der ersten Sorte InₓGa₁₋ₓN, wobei x ≤ 0.03, die Quantentöpfe der ersten Sorte InₓGa₁₋ₓN, wobei x ≈ 0.08, die Sperrschichten der zweiten Sorte InₓGa₁₋ₓN, wobei x ≤ 0.05, und enthält der Quantentopf der zweiten Sorte InₓGa₁₋ₓN, wobei x ≤ 0.18.

Das von den Quantentöpfen der ersten Sorte emittierte Licht hat eine Peakwellenlänge λ4 die zwischen 400 nm und 450 nm liegt.

Das von dem Quantentopf der zweiten Sorte emittierte Licht hat eine Peakwellenlänge λ5, die zwischen 450 nm und 500 nm liegt.

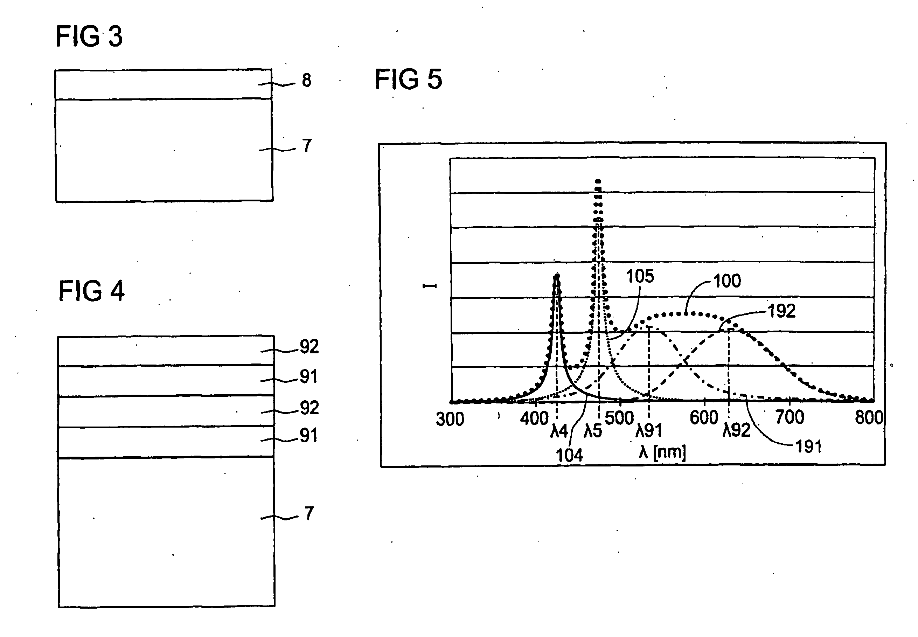

Figur 3 zeigt ein Bauelement, bei dem auf einer lichtemittierenden Struktur 7, wie sie beispielsweise in Figur 1 dargestellt ist, eine Leuchtstoffschicht 8 aufgebracht ist. Die Leuchtstoffschicht 8 enthält dabei eine Mischung von Leuchtstoffen.

Die Leuchtstoffschicht 8 kann bei dem Beispiel von Figur 3 blau emittierenden Leuchtstoff in Form von Nitrid-Silikat basiertem Leuchtstoff enthalten. Grün emittierender Leuchtstoff kann beispielsweise als YAG-basierter Leuchtstoff vorliegen. Beispielsweise kann als Leuchtstoff der Stoff YAG:Ce (Y₃Al₅O₁₂:Ce³⁺) verwendet werden.

Die Leuchtstoffschicht 8 kann das von der lichtemittierenden Struktur 7 abgestrahlte Licht teilweise absorbieren im Sinne eines Pumpvorganges und selbst Licht von verschiedenen Wellenlängen abstrahlen.

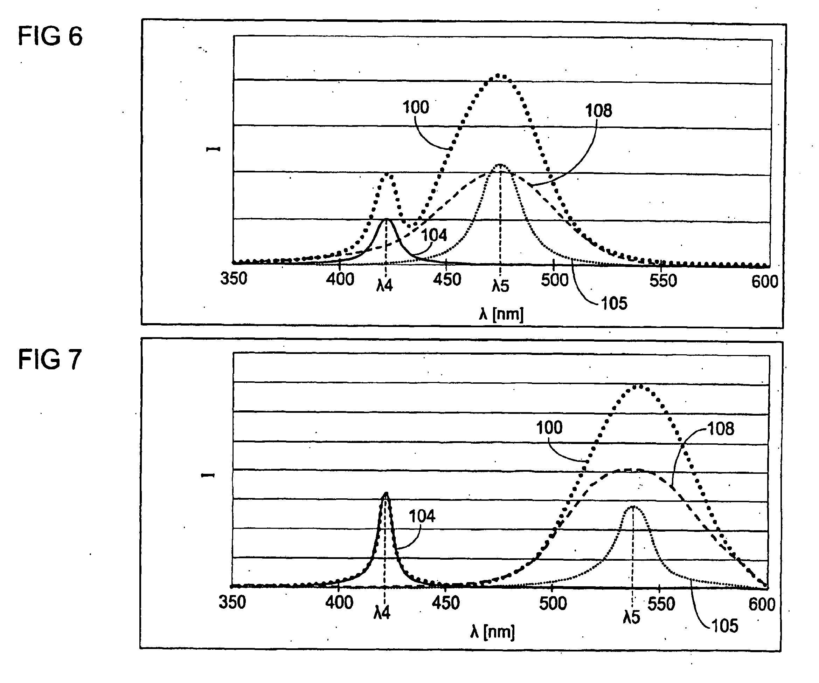

Das abgestrahlte Licht einer gemäß Figur 3 gezeigten Anordnung ist beispielsweise in Figur 6 gezeigt. Neben den Peakwellenlängen λ4 und λ5, die ähnlich wie in Figur 2 zustande kommen, existiert noch das von der Leuchtstoffschicht 8 emittierte Licht, dessen Intensität in Abhängigkeit von der Wellenlänge durch die Kurve 108 in Figur 6 gezeigt ist. Das von der Leuchtstoffschicht 8 abgestrahlte Licht überlagert sich mit der Strahlung mit den Peakwellenlängen λ4 und λ5 zu einer gesamten Abstrahlung, die durch das Gesamtspektrum 100 angegeben ist. Man erkennt, dass durch den Einsatz der Leuchtstoffschicht 8 vor allem die Breite des im blauen Spektralbereich abgestrahlten Peaks deutlich verbreitert werden kann, was die Wahrnehmung durch das menschliche Auge angenehmer macht.

Ein weiteres Beispiel ist in Figur 7 gezeigt. In diesem Fall ist der Strahlungspeak des Quantentopfes der zweiten Sorte im Bereich zwischen 500 nm und 550 nm gewählt. Durch entsprechende Wahl der Leuchtstoffschicht 8 kann eine Emission der Leuchtstoffschicht 8 ebenfalls in diesem Wellenlängenbereich erreicht werden. Das von der Leuchtstoffschicht 8 abgestrahlte Licht ist durch die Kurve 108 gezeigt. Im Gesamtspektrum, das durch die Kurve 100 angegeben ist, zeigt sich, dass durch die Verwendung der Leuchtstoffschicht 8 eine Verbreiterung des Strahlungspeaks im Bereich des grünen Lichts bei der Peakwellenlänge im Bereich der Peakwellenlänge λ5 ergibt. Dadurch wird der Lichteindruck für das menschliche Auge angenehmer gemacht.

Figur 4 zeigt ein Bauelement, bei dem auf der Oberseite einer lichtemittierenden Struktur 7 ebenfalls Leuchtstoff angeordnet ist. Im Unterschied zur Ausführungsform nach Figur 3 sind zwei verschiedene Sorten von Leuchtstoffen in abwechselnd übereinander gelegten Schichten vorgesehen. Hierbei wechseln Leuchtstoffschichten 91 einer ersten Sorte sich mit Leuchtstoffschichten 92 einer zweiten Sorte ab.

Die Leuchtstoffschicht 91 kann vorzugsweise ein grün emittierender Leuchtstoff sein, während für die Leuchtstoffschicht 92 ein gelb-rot (orange) emittierender Leuchtstoff gewählt wird. Ein Unterschied zwischen den Leuchtstoffschichten 91 und 92 kann in der Anregungseffizienz liegen. Die Anregungseffizienz der Leuchtstoffschicht 91 ist für die Wellenlänge λ4 besser, während die Leuchtstoffschicht 92 eine bessere Anregungseffizienz für die Wellenlängen λ5 aufweist.

Mit Hilfe der Ausführungsform nach Figur 4 kann ein Strahlungsspektrum erreicht werden, wie es in Figur 5 gezeigt ist. Dabei werden durch die Verwendung unterschiedlicher Leuchtstoffmaterialien auch unterschiedliche Lichtwellenlänge von den Leuchtstoffmaterialien emittiert. Die Leuchtstoffschicht 91 der ersten Sorte strahlt dabei Licht mit einer Peakwellenlänge λ91 ab. Die Intensität in Abhängigkeit von der Wellenlänge ist angegeben durch die Kurve 191. Die Leuchtstoffschicht 92 der zweiten Sorte strahlt Licht mit einer Peakwellenlänge λ92 ab, die größer ist als die Peakwellenlänge λ91. Die Intensität des durch die Leuchtstoffschicht 92 der zweiten Sorte abgestrahlten Lichts ist durch die Kurve 192 dargestellt. Im Gesamtspektrum 100 ergibt sich eine sehr ausgeglichene Intensität, die vom blauen Bereich zwischen 500 nm bis jenseits der 600 nm reicht. Der in Figur 4 gezeigte 4-Wellenlängen-Emitter kann eine gute Farbverteilung erzeugen und den vom menschlichen Auge wahrgenommen Farbeindruck verbessern. Dies wird vor allem ermöglicht durch eine bessere Abdeckung im grünen Bereich des Farbspektrums.

Ein Vorteil in der gezeigten Vielschichtanordnung liegt darin, dass es möglich wird, die Konversion auf Chipebene durch die Verwendung relativ dünner Schichten durchzuführen. Insbesondere kann die Dicke der Schichten durch wiederholtes Abscheiden dünner Schichten insgesamt vergrößert werden, wodurch die Effizienz der Lichtkonversion ebenfalls verbessert wird.

Darüber hinaus kann das endgültig Emissionsspektrum durch die Anpassung der Dicke der Leuchtstoffschichten 91 und der Leuchtstoffschichten 92 erfolgen.

## Patentansprüche

1. Lichtemittierende Struktur (7), enthaltend
- ein p-dotiertes Gebiet (1) zur Injektion von Löchern,
- ein n-dotiertes Gebiet (2) zur Injektion von Elektronen,
- eine aktive Zone mit mehreren InGaN-Quantentöpfen (4) einer ersten Sorte und mindestens einem InGaN-Quantentopf (5) einer zweiten Sorte, die zwischen dem n-dotierten Gebiet (2) und dem p-dotierten Gebiet (1) angeordnet ist, wobei der InGaN-Quantentopf (5) der zweiten Sorte einen höheren Indiumgehalt aufweist als die InGaN-Quantentöpfe (4) der ersten Sorte, wobei die InGaN-Quantentöpfe (4) der ersten Sorte durch (In)GaN-Sperrschichten (3) einer ersten Sorte voneinander getrennt sind und wobei zwischen dem Quantentopf (5) der zweiten Sorte und einem randständigen Quantentopf (4) der ersten Sorte eine Sperrschicht (6) einer zweiten Sorte angeordnet ist,
**dadurch gekennzeichnet, dass**
die Sperrschichten (3) der ersten Sorte Silizium-dotiert sind mit einer Konzentration zwischen 1,0 x 10¹⁷ 1/cm³ und 2,0 x 10¹⁹ 1/cm³, und
die Sperrschicht (6) der zweiten Sorte mit Silizium dotiert ist mit einer Konzentration von nicht mehr als 5 x 10¹⁷ 1/cm³.

2. Lichtemittierende Struktur (7) nach Anspruch 1,
bei der eine Differenz zwischen dem Indiumgehalt in den Sperrschichten (3) der ersten Sorte und den Quantentöpfen (4) der ersten Sorte kleiner als 7 % ist.

3. Lichtemittierende Struktur (7) nach einem der vorhergehenden Ansprüche, wobei der mindestens eine Quantentopf (4) der ersten Sorte an das n-dotierte Gebiet (2) und der mindestens eine Quantentopf (5) der zweiten Sorte an das p-dotierte Gebiet (1) angrenzt.

4. Lichtemittierende Struktur (7) nach einem der vorhergehenden Ansprüche,
bei der der Indiumgehalt des mindestens einen Quantentopfes (4) der ersten Sorte so eingestellt ist, dass er Strahlung in einem Wellenlängenbereich zwischen 370 nm und 440 nm emittiert.

5. Lichtemittierende Struktur (7) nach einem der vorhergehenden Ansprüche,
bei der die Sperrschichten (3) der ersten Sorte einen Indiumgehalt kleiner fünf Prozent aufweisen.

6. Lichtemittierende Struktur (7) nach einem der vorhergehenden Ansprüche,
wobei der Indiumgehalt des Quantentopfs (5) der zweiten Sorte so eingestellt ist, dass er Strahlung in einem Wellenlängenbereich zwischen 440 nm und 580 nm emittiert.

7. Lichtemittierende Struktur (7) nach einem der vorhergehenden Ansprüche,
bei der der Indiumgehalt der Quantentöpfe (5) der zweiten Sorte zwischen 12 % und 25 % beträgt,
und eine Dicke der Quantentöpfe (5) der zweiten Sorte zwischen 2 nm und 7 nm liegt.

8. Lichtemittierende Struktur (7) nach einem der vorhergehenden Ansprüche,
bei der eine Dicke (d3) der Sperrschichten (3) der ersten Sorte von einer Dicke (d6) der Sperrschicht (6) der zweiten Sorte unterschiedlich gewählt ist.

9. Lichtemittierende Struktur (7) nach einem der vorhergehenden Ansprüche,
bei der die Dicken (d3, d6) der Sperrschichten (3, 6) zwischen 3 nm und 15 nm betragen.

10. Lichtemittierende Struktur (7) nach einem der vorhergehenden Ansprüche,
bei der die Anzahl der Quantentöpfe (4) der ersten Sorte zwischen 2 und 30 beträgt.

11. Lichtemittierende Struktur (7) nach einem der vorhergehenden Ansprüche,
bei der der randständige Quantentopf (4) der ersten Sorte und ein Quantentopf (5) der zweiten Sorte direkt an die Sperrschicht (6) der zweiten Sorte grenzen,
und/oder die genau einen Quantentopf (5) der zweiten Sorte und genau eine Sperrschicht (6) der zweiten Sorte aufweist.

12. Bauelement mit einer lichtemittierenden Struktur (7) nach einem der vorhergehenden Ansprüche,
bei dem in Abstrahlrichtung der Quantentöpfe nachgeordnet ein Leuchtstoff angeordnet ist, der durch das Licht der Quantentöpfe (4, 5) optisch gepumpt wird.

13. Bauelement nach Anspruch 12,
bei dem eine Mischung mehrerer Leuchtstoffe verwendet wird, wobei die Mischung ähnliche Emissionswellenlängen wie der Quantentopf (5) der zweiten Sorte aufweist.

14. Bauelement nach einem der Ansprüche 12 oder 13,
bei dem im Strahlengang ein Absorber für UV-Licht oder violettes Licht angeordnet ist.

## Claims

1. Light-emitting structure (7), containing
- a p-doped region (1) for injecting holes,
- an n-doped region (2) for injecting electrons,
- an active zone having a plurality of InGaN quantum wells (4) of a first type and at least one InGaN quantum well (5) of a second type, which is arranged between the n-doped region (2) and the p-doped region (1), wherein the InGaN quantum well (5) of the second type has a higher indium content than the InGaN quantum wells (4) of the first type, wherein the InGaN quantum wells (4) of the first type are separated from one another by (In)GaN barrier layers (3) of a first type, and wherein a barrier layer (6) of a second type is arranged between the quantum well (5) of the second type and a marginal quantum well (4) of the first type,
**characterized in that**
the barrier layers (3) of the first type are silicon-doped with a concentration of between 1.0 × 10¹⁷ 1/cm³ and 2.0 × 10¹⁹ 1/cm³, and
the barrier layer (6) of the second type is doped with silicon with a concentration of not more than 5 × 10¹⁷ 1/cm³.

2. Light-emitting structure (7) according to Claim 1, wherein a difference between the indium content in the barrier layers (3) of the first type and the quantum wells (4) of the first type is less than 7%.

3. Light-emitting structure (7) according to either of the preceding claims, wherein the at least one quantum well (4) of the first type adjoins the n-doped region (2) and the at least one quantum well (5) of the second type adjoins the p-doped region (1).

4. Light-emitting structure (7) according to any of the preceding claims,
wherein the indium content of the at least one quantum well (4) of the first type is set such that it emits radiation in a wavelength range of between 370 nm and 440 nm.

5. Light-emitting structure (7) according to any of the preceding claims,
wherein the barrier layers (3) of the first type have an indium content of less than five per cent.

6. Light-emitting structure (7) according to any of the preceding claims,
wherein the indium content of the quantum well (5) of the second type is set such that it emits radiation in a wavelength range of between 440 nm and 580 nm.

7. Light-emitting structure (7) according to any of the preceding claims,
wherein the indium content of the quantum wells (5) of the second type is between 12% and 25%,
and a thickness of the quantum wells (5) of the second type is between 2 nm and 7 nm.

8. Light-emitting structure (7) according to any of the preceding claims,
wherein a thickness (d3) of the barrier layers (3) of the first type is chosen to be different from a thickness (d6) of the barrier layer (6) of the second type.

9. Light-emitting structure (7) according to any of the preceding claims,
wherein the thicknesses (d3, d6) of the barrier layers (3, 6) are between 3 nm and 15 nm.

10. Light-emitting structure (7) according to any of the preceding claims,
wherein the number of quantum wells (4) of the first type is between 2 and 30.

11. Light-emitting structure (7) according to any of the preceding claims,
wherein the marginal quantum well (4) of the first type and a quantum well (5) of the second type directly adjoin the barrier layer (6) of the second type,
and/or which comprises exactly one quantum well (5) of the second type and exactly one barrier layer (6) of the second type.

12. Component comprising a light-emitting structure (7) according to any of the preceding claims,
wherein a phosphor is arranged downstream in the emission direction of the quantum wells, said phosphor being optically pumped by the light from the quantum wells (4, 5).

13. Component according to Claim 12,
wherein a mixture of a plurality of phosphors is used, wherein the mixture has emission wavelengths similar to those of the quantum well (5) of the second type.

14. Component according to either of Claims 12 and 13,
wherein an absorber for UV light or violet light is arranged in the beam path.

## Revendications

1. Structure émettrice de lumière (7) comprenant :
- une région dopée p (1) destinée à l'injection de trous,
- une région dopée n (2) destinée à l'injection d'électrons,
- une zone active comportant des puits quantiques d'InGaN (4) d'un premier type et au moins un puits quantique d'InGaN (5) d'un second type qui sont disposés entre la région dopée n (2) et la région dopée p (1), dans lequel le puits quantique d'InGaN (5) du second type comprend une teneur en indium plus élevée que les puits quantiques d'InGaN (4) du premier type, dans lequel les puits quantiques d'InGaN (4) du premier type sont séparés les uns des autres par des couches barrières d'(In)GaN (3) d'un premier type et dans lequel une couche barrière (6) d'un second type est disposée entre le puits quantique (5) du second type et un puits quantique marginal (4) du premier type,
**caractérisé en ce que**
les couches barrières (3) du premier type sont dopées par du silicium à une concentration comprise entre 1,0 x 10¹⁷ 1/cm³ et 2,0 x 10¹⁹ 1/cm³, et
la couche barrière (6) du second type est dopée par du silicium à une concentration non supérieure à 5 x 10¹⁷ 1/cm³.

2. Structure émettrice de lumière (7) selon la revendication 1, dans laquelle la différence entre la teneur en indium des couches barrières (3) du premier type et les puits quantiques (4) du premier type est inférieure à 7 %.

3. Structure émettrice de lumière (7) selon l'une quelconque des revendications précédentes, dans laquelle l'au moins un puits quantique (4) du premier type est adjacent à la région dopée n (2) et l'au moins un puits quantique (5) du second type est adjacent à la région dopée p (1).

4. Structure émettrice de lumière (7) selon l'une quelconque des revendications précédentes,
dans laquelle la teneur en indium de l'au moins un puits quantique (4) du premier type est réglée de manière à ce que celui-ci émette un rayonnement dans une gamme de longueurs d'onde compris entre 370 nm et 440 nm.

5. Structure émettrice de lumière (7) selon l'une quelconque des revendications précédentes,
dans laquelle les couches barrières (3) du premier type présentent une teneur en indium inférieure à cinq pour cent.

6. Structure émettrice de lumière (7) selon l'une quelconque des revendications précédentes,
dans laquelle la teneur en indium du puits quantique (5) du second type est réglée de manière à ce que celui-ci émette un rayonnement dans une gamme de longueurs d'onde comprise entre 440 nm et 580 nm.

7. Structure émettrice de lumière (7) selon l'une quelconque des revendications précédentes,
dans laquelle la teneur en indium des puits quantiques (5) du second type est comprise entre 12 % et 25 %,
et une épaisseur des puits quantiques (5) du second type se situe entre 2 nm et 7 nm.

8. Structure émettrice de lumière (7) selon l'une quelconque des revendications précédentes,
dans laquelle une épaisseur (d3) des couches barrières (3) du premier type est sélectionnée de manière à être différente d'une épaisseur (d6) de la couche barrière (6) du second type.

9. Structure émettrice de lumière (7) selon l'une quelconque des revendications précédentes,
dans laquelle les épaisseurs (d3, d6) des couches barrières (3, 6) sont comprises entre 3 nm et 15 nm.

10. Structure émettrice de lumière (7) selon l'une quelconque des revendications précédentes,
dans laquelle le nombre des puits quantiques (4) du premier type est compris entre 2 et 30.

11. Structure émettrice de lumière (7) selon l'une quelconque des revendications précédentes,
dans laquelle le puits quantique marginal (4) du premier type et un puits quantique (5) du second type sont directement adjacents à la couche barrière (6) du second type,
et/ou comprenant exactement un puits quantique (5) du second type et exactement une couche barrière (6) du second type.

12. Composant comportant une structure émettrice de lumière (7) selon l'une quelconque des revendications précédentes,
dans lequel, en aval des puits quantiques, dans la direction de rayonnement, est disposé un matériau luminescent qui est soumis à un pompage optique par la lumière des puits quantiques (4, 5).

13. Composant selon la revendication 12,
dans lequel on utilise un mélange de plusieurs matériaux luminescents, dans lequel le mélange présente des longueurs d'onde d'émission semblables à celles du puits quantique (5) du second type.

14. Composant selon l'une quelconque des revendications 12 ou 13,
dans lequel un absorbant de la lumière UV ou de la lumière violette est disposé sur le chemin optique.
